# EUROPEAN PATENT SPECIFICATION

(11) **EP 4 084 594 B1**
(45) Date of publication and mention of the grant of the patent: **19.04.2023**
(21) Application number: 21199658.2
(22) Date of filing: 29.09.2021
(51) Int. Cl.: H05K 7/20

(54) **COOLING CIRCUITS FOR COOLING A COMPUTING SYSTEM AND FLOW CONTROL METHODS THEREOF**
KÜHLKREISLÄUFE ZUR KÜHLUNG EINES RECHNERSYSTEMS UND FLUSSSTEUERUNGSVERFAHREN DAFÜR
CIRCUITS DE REFROIDISSEMENT POUR REFROIDIR UN SYSTÈME INFORMATIQUE ET PROCÉDÉS DE RÉGLAGE DE DÉBIT ASSOCIÉS

(30) Priority: 30.04.2021 US 202163182360 P; 20.07.2021 US 202117380845
(43) Date of publication of application: 02.11.2022
(73) Proprietor: Quanta Computer Inc., Taoyuan City 33377 (TW)
(72) Inventor: CHEN, Yi-Chieh, 33377 Taoyuan City (TW); WU, Yueh-Chang, 33377 Taoyuan City (TW); WANG, Te-Chuan, 33377 Taoyuan City (TW); HSU, Tzu-Hsuan, 33377 Taoyuan City (TW)
(74) Representative: dompatent von Kreisler Selting Werner - Partnerschaft von Patent- und Rechtsanwälten mbB

(56) References cited:
- WO-A1-2020/234599

## Description

### FIELD OF THE INVENTION

The present invention relates generally to systems and method for cooling a computing system, and more specifically, to cooling circuits for cooling a computing system and flow control methods thereof.

### BACKGROUND OF THE INVENTION

Computing devices (such as servers) typically contain one or more heat-generating components, such as a central processing unit (CPU), a graphics processing unit (GPU), and others. To aid in cooling these heat-generating components, cooling modules containing pumps for driving a cooling fluid and transferring heat away from the heat-generating components may be used. However, when a pump in any one of the cooling modules fails, at least the cooling module with the failed pump becomes unable to cool the heat-generating components thermally coupled thereto and may also affect any cooling module connected in series.

Accordingly, it is desirable to have better cooling solutions that can ensure pump redundancy during operation such that heat from the heat-generating components in all parts of the computing devices can continue to be effectively removed.

### SUMMARY OF THE INVENTION

The invention is defined by the features of independednt claims 1 and 8. Further embodiments are defined in the dependent claims.

According to the invention there is provided a cooling system for a rack of servers, comprising:a plurality of cooling circuits, each cooling circuit coupled to a server of the rack and comprising:a plurality of cooling modules arranged in parallel, each cooling module including a cold plate having a cooling conduit passing therethrough, and a pump fluidly coupled to the cooling conduit;a first cooling distribution manifold fluidly connected to the cooling circuit of each of the plurality of servers through an inlet pipe; and a second cooling distribution manifold fluidly connected to the cooling circuit of each of the plurality of servers through an outlet pipe;wherein the cooling system is characterized in that any two adjacent cooling modules are interconnected by a valve having four ports, the valve is one of a four-pass actuated ball valve and a four-pass valve formed by three two-pass solenoid valves, two of the ports are fluidly coupled to an outlet tube of each cooling module, and another two of the ports are fluidly coupled to an inlet tube of each cooling module.

According to certain aspects of the present disclosure, a cooling circuit for cooling a computing system is disclosed. The cooling circuit includes a plurality of cooling modules arranged in parallel. Each cooling module includes a cold plate having a cooling conduit passing therethrough, and a pump fluidly coupled to the cooling conduit. The cooling circuit further includes one or more valves fluidly interconnecting the plurality of cooling modules. Each of the one or more valves, when turned on, fluidly connects the cooling conduits of any two adjacent cooling modules.

According to certain aspects of the present disclosure, a cooling system for a rack of servers is disclosed. The cooling system includes a plurality of cooling circuits, where each cooling circuit is coupled to a server of the rack. Each cooling circuit includes a plurality of cooling modules arranged in parallel. Each cooling module includes a cold plate having a cooling conduit passing therethrough, and a pump fluidly coupled to the cooling conduit. The cooling circuit further includes one or more valves fluidly interconnecting the plurality of cooling modules. Each of the one or more valves, when turned on, fluidly connects the cooling conduits of any two adjacent cooling modules. The cooling system further includes a first cooling distribution manifold fluidly connected to the cooling circuit of each of the plurality of servers through an inlet pipe, and a second cooling distribution manifold fluidly connected to the cooling circuit of each of the plurality of servers through an outlet pipe.

According to certain aspects of the present disclosure, each cooling module further includes an inlet tube and an outlet tube. The inlet tube has a first end coupled to a first quick connector and a second end coupled to an inlet of the cooling conduit. The outlet tube has a first end coupled to an outlet of the cooling conduit and a second end coupled to a second quick connector.

According to certain aspects of the present disclosure, the one or more valves is a four-pass actuated ball valve, or a four-pass valve formed by three two-pass solenoid valves.

According to certain aspects of the present disclosure, the cooling circuit includes two cooling modules interconnected by one valve.

According to certain aspects of the present disclosure, each of the plurality of cooling modules is disposed above a heat-generating component of the corresponding server.

According to certain aspects of the present disclosure, the cooling system further includes a cooling distribution unit disposed on the rack of servers for distributing a cooling fluid to the first cooling distribution manifold and receiving the cooling fluid from the second cooling distribution manifold.

According to certain aspects of the present disclosure, the cooling distribution unit further includes one or more sensors, a cooling distribution pump, and a programmable logic controller. The sensors are configured to detect one or more flow parameters of the cooling fluid. The cooling distribution pump is configured to controllably distribute the cooling fluid. The programmable logic controller is configured to control the flow rate of the cooling fluid from the cooling distribution pump based on data received on the one or more flow parameters of the cooling fluid.

According to certain aspects of the present disclosure, each cooling circuit is communicatively coupled to a controller in the corresponding server. The controller is configured to detect whether one or more of the pumps in the plurality of cooling modules has failed. The controller is further configured to turn on the one or more valves fluidly connecting the cooling conduit of the cooling module having each of the one or more failed pumps with the cooling conduit of an adjacent cooling module, in response to such detection.

According to certain aspects of the present disclosure, the controller is further configured to receive temperature information of a heat-generating component thermally connected with the cold plate from a temperature sensor in the corresponding server. The controller is further configured to adjust an electrical power load on the heat-generating component, in response to detecting that the one or more of the pumps in the plurality of cooling modules has failed.

According to certain aspects of the present disclosure, the controller is further configured to send an alarm to an operator, in response to detecting at least that all but one of the pumps in the plurality of cooling modules has failed.

According to certain aspects of the present disclosure, the controller is further configured to detect whether the one or more pumps has failed by receiving information on the revolutions per minute (RPM) of the one or more pumps, and determining whether the RPM of any of the one or more pumps is outside a predetermined range of values.

According to the invention a flow control method for a cooling circuit of a computing system is disclosed. The method includes cooling the computing system, characterized in that the method comprises:cooling the computing system via a plurality of cooling modules,each cooling module having a pump fluidly connected to a cooling conduit that passes through a cold plate of the cooling module;detecting failure of a pump in one or more of the plurality of cooling modules; andin response to detecting the failure, turning on a valve having four ports to flow a coolant between the cooling conduit fluidly connected to each of the failed pumps and the cooling conduit of an adjacent cooling module , wherein any two adjacent cooling modules are interconnected by the valve, the valve is one of a four-pass actuated ball valve and a four-pass valve formed by three two-pass solenoid valves, two of the ports are fluidly coupled to an outlet tube of each cooling module, and another two of the ports are fluidly coupled to an inlet tube of each cooling module.

According to certain aspects of the present disclosure, the method further includes adjusting electrical power load on a heat-generating component thermally coupled to the cooling circuit, in response to detecting the failure.

According to certain aspects of the present disclosure, the method further includes sending an alarm to an operator, in response to detecting at least that all but one of the pumps in the plurality of cooling modules have failed.

According to certain aspects of the present disclosure, the method detects the failure of a pump in one or more of the plurality of cooling modules by receiving information on the revolutions per minute (RPM) of the one or more pumps and determining whether the RPM of any of the one or more pumps is outside a predetermined range of values.

The invention is limited by the appended claims.

### BRIEF DESCRIPTION OF THE DRAWINGS

The disclosure, and its advantages and drawings, will be better understood from the following description of representative embodiments together with reference to the accompanying drawings.
FIG. 1 shows a side view of a schematic depiction of a rack of servers with the cooling system having a plurality of cooling circuits, according to certain aspects of the present disclosure.
FIG. 2A shows a side view of a first embodiment of a cooling module disposed in each of the plurality of cooling circuits of FIG. 1, according to certain aspects of the present disclosure.
FIG. 2B shows a side view of a second embodiment of a cooling module disposed in each of the plurality of cooling circuits of FIG. 1, according to certain aspects of the present disclosure.
FIG. 3A shows a top view of a schematic depiction of two adjacent cooling circuits interconnected by one valve that is turned off, according to certain aspects of the present disclosure.
FIG. 3B shows a top view of a schematic depiction of two adjacent cooling circuits interconnected by one valve that is turned on to allow cooling fluid to flow between the cooling circuits, according to certain aspects of the present disclosure.
FIG. 4A shows a top view of a schematic depiction of three adjacent cooling circuits interconnected by two valves that are turned off, according to certain aspects of the present disclosure.
FIG. 4B shows a top view of a schematic depiction of three adjacent cooling circuits interconnected by the two valves that are turned on to allow cooling fluid to flow among the adjacent cooling circuits, according to certain aspects of the present disclosure.
FIG. 5A shows a perspective view of a first embodiment of a valve used for interconnecting the adjacent cooling circuits, according to certain aspects of the present disclosure.
FIG. 5B shows a top view of the valve of FIG. 5A, according to certain aspects of the present disclosure.
FIG. 5C shows a schematic configuration of "on" and "off' states of the valve of FIG. 5A, according to certain aspects of the present disclosure.
FIG. 6A shows a perspective view of a second embodiment of a valve used for interconnecting the adjacent cooling circuits, according to certain aspects of the present disclosure.
FIG. 6B shows a schematic representation of the valve of FIG. 6A, according to certain aspects of the present disclosure.
FIG. 7 shows a schematic representation of the operation of a controller in each server of the rack of servers of FIG. 1 to control the cooling circuit of the server, according to certain aspects of the present disclosure.
FIG. 8 shows a flow diagram of a flow control method executed by the controller of FIG. 7, according to certain aspects of the present disclosure.
FIG. 9 shows a block diagram of a flow control method for cooling the cooling circuit of each server of FIG. 1, according to certain aspects of the present disclosure.

The present disclosure is susceptible to various modifications and alternative forms, and some representative embodiments have been shown by way of example in the drawings and will be described in detail herein. It should be understood, however, that the invention is limited by the appended claims.

### DETAILED DESCRIPTION

Embodiments of the disclosure are directed to cooling circuits for cooling a computing system and flow control methods thereof. The cooling circuits include a plurality of cooling modules arranged in parallel and interconnected by one or more valves that, when turned on, fluidly connects adjacent cooling modules. This ensures that a cooling fluid can flow across the plurality of cooling modules, if a pump for driving the cooling fluid in any one of the plurality of cooling modules fails. The flow control methods for the cooling circuit are executed by a controller that detects the failed pump and turns on the valve between adjacent cooling modules such that the cooling fluid can flow through. In response to such detection, the controller may also adjust the electrical power load of a heat-generating component thermally coupled to the cooling module having the failed pump. The controller is also configured to send an alarm to an operator, in the event all but one of the pumps in the plurality of cooling modules have failed.

Various embodiments are described with reference to the attached figures, where like reference numerals are used throughout the figures to designate similar or equivalent elements. The figures are not necessarily drawn to scale and are provided merely to illustrate aspects and features of the present disclosure. Numerous specific details, relationships, and methods are set forth to provide a full understanding of certain aspects and features of the present disclosure, although one having ordinary skill in the relevant art will recognize that these aspects and features can be practiced without one or more of the specific details, with other relationships, or with other methods. In some instances, well-known structures or operations are not shown in detail for illustrative purposes. The various embodiments disclosed herein are not necessarily limited by the illustrated ordering of acts or events, as some acts may occur in different orders and/or concurrently with other acts or events. Furthermore, not all illustrated acts or events are necessarily required to implement certain aspects and features of the present disclosure.

For purposes of the present detailed description, unless specifically disclaimed, and where appropriate, the singular includes the plural and vice versa. The word "including" means "including without limitation." Moreover, words of approximation, such as "about," "almost," "substantially," "approximately," and the like, can be used herein to mean "at," "near," "nearly at," "within 3-5% of," "within acceptable manufacturing tolerances of," or any logical combination thereof. Similarly, terms "vertical" or "horizontal" are intended to additionally include "within 3-5% of" a vertical or horizontal orientation, respectively. Additionally, words of direction, such as "top," "bottom," "left," "right," "above," and "below" are intended to relate to the equivalent direction as depicted in a reference illustration; as understood contextually from the object(s) or element(s) being referenced, such as from a commonly used position for the object(s) or element(s); or as otherwise described herein.

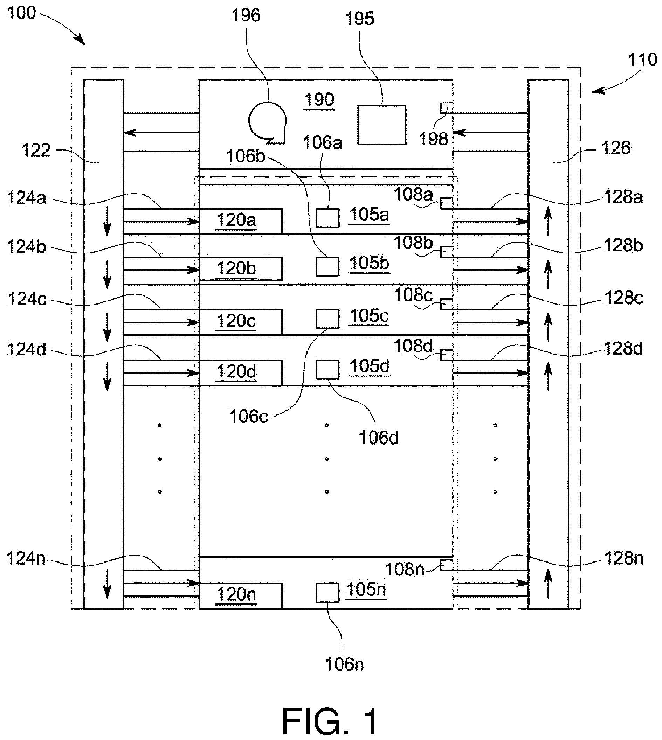

FIG. 1 shows a side view of a schematic depiction of a rack 100 of 'n' servers 105a, 105b, ..., 105n. The letter 'n' is used throughout this specification to denote a plurality of components and represents an integer greater than two. The rack 100 has a cooling system 110 with a plurality of cooling circuits 120a, 120b, ..., 120n. Each cooling circuit 120n is coupled to and disposed within each server 105n of the rack 100. Each of the plurality of cooling circuits 120a, 120b, ..., 120n is communicatively coupled to a corresponding controller 106a, 106b, ..., 106n in the respective server 105a, 105b, ..., 105n. Each controller 106n is configured to control the flow of a cooling fluid through the corresponding cooling circuit 120n and undertake actions to ensure continuity and effectiveness of cooling performed thereby.

The cooling system 110 includes a first cooling distribution manifold 122 fluidly connected to the cooling circuits 120a, 120b, ..., 120n of the respective servers 105a, 105b, ..., 105n through inlet pipes 124a, 124b, ..., 124n for distributing a cooling fluid into each of the cooling circuits 120a, 120b, ..., 120n. The cooling system 110 further includes a second cooling distribution manifold 126 fluidly connected to the cooling circuits 120a, 120b, ..., 120n of the respective servers 105a, 105b, ..., 105n through outlet pipes 128a, 128b, ..., 128n for removing the cooling fluid from each of the cooling circuits 120a, 120b, ..., 120n. In some embodiments, the first cooling distribution manifold 122 and the second cooling distribution manifold 126 may be made from aluminum, stainless steel, and the like. Temperature sensors 108a, 108b, ..., 108n are disposed adjacent to the outlet pipes 128a, 128b, ..., 128n within each of the servers 105a, 105b, ..., 105n.

The cooling system 110 includes a cooling distribution unit 190 disposed on the rack 100. The cooling distribution unit 190 distributes a cooling fluid to the first cooling distribution manifold 122 and receives the cooling fluid from the second cooling distribution manifold 126. The cooling distribution unit 190 includes one or more sensors 198, a cooling distribution pump 196, and a programmable logic controller 195. The sensor(s) 198 are configured to detect one or more flow parameters of the cooling fluid. As non-limiting examples, the flow parameters may be pressure, flow rate, and the like. The cooling distribution pump 196 is configured to controllably distribute the cooling fluid. The programmable logic controller 195 is configured to control the flow rate of the cooling fluid from the cooling distribution pump 196 based on data received on the flow parameters of the cooling fluid from the sensor(s) 198.

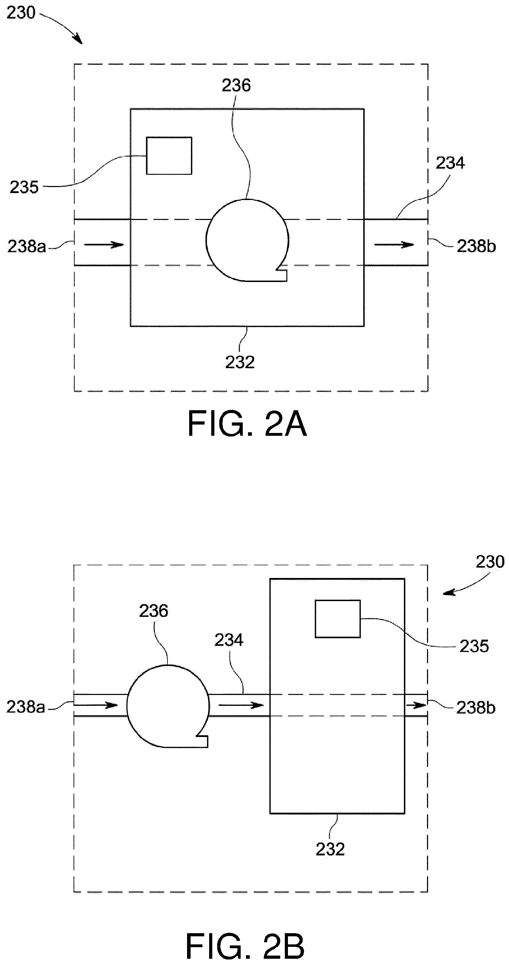

FIGS. 2A-2B show side views of a first embodiment and a second embodiment of a cooling module 230 disposed in each of the plurality of cooling circuits 120a, 120b, ..., 120n (FIG. 1). The cooling modules 230 is positioned (e.g., disposed above, disposed under, etc.) to be thermally coupled to a heat-generating component 235 (e.g., a processor, memory card, etc.) of the server 105n. The cooling module 230 includes a cold plate 232 having a cooling conduit 234 passing therethrough. The cooling conduit 234 has an inlet 238a and an outlet 238b. A cooling fluid enters the cooling module 230 through the inlet 238a and exits the cooling module 230 through the outlet 238b. A pump 236 is fluidly coupled to the cooling conduit 234 for distributing the cooling fluid to and from the cooling module 230. The pump 236 may be in fluid contact with the cold plate 232, as shown in the first embodiment of FIG. 2A. The pump 236 may also be in fluid contact with the cooling conduit 234, as shown in the second embodiment of FIG. 2B.

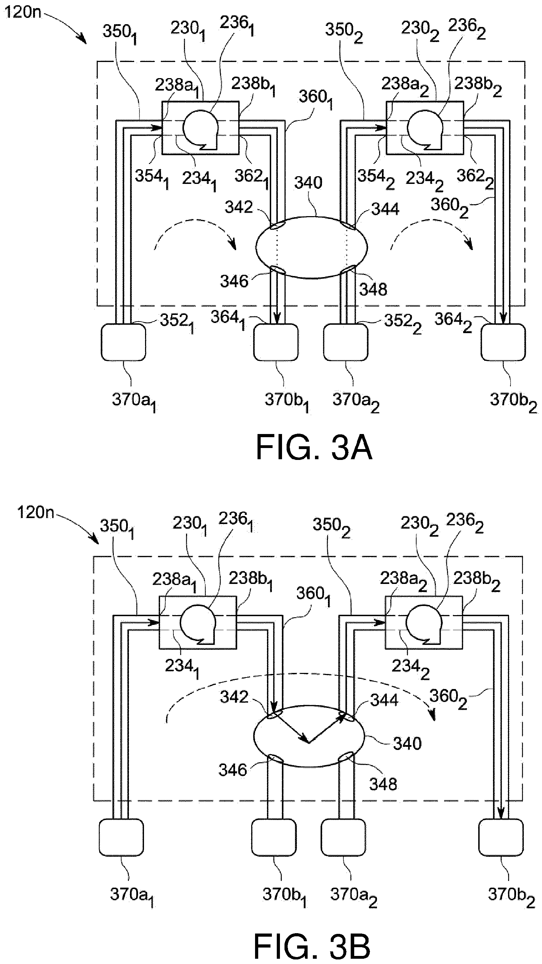

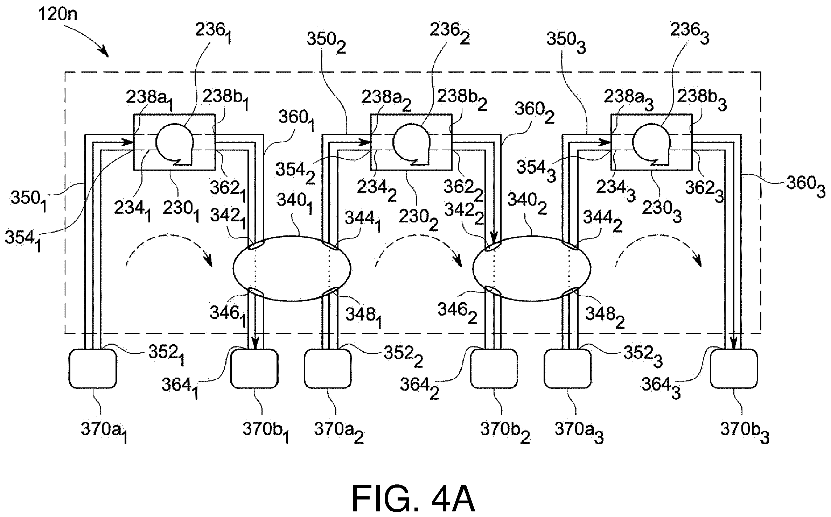

The plurality of cooling modules 230 in each cooling circuit 120n are shown in further detail in FIGS. 3A-3B and FIGS. 4A-4B. The plurality of cooling modules 230 are interconnected by one or more valves (e.g., valve 340 in FIGS. 3A-3B) that, when turned on, fluidly connect the cooling conduits 234 of adjacent cooling modules 230. FIGS. 3A-3B show top views of a schematic depiction of an example arrangement of two adjacent cooling modules 230₁, 230₂ arranged in parallel and interconnected by one valve 340 that is initially turned off (FIG. 3A) and then turned on to allow cooling fluid to flow between the adjacent cooling modules 230₁, 230₂ (FIG. 3B). The cooling module 230₁ is thermally coupled to a heat-generating component (not shown). As shown in FIG. 3A, the cooling module 230₁ includes a pump 236₁ fluidly connected to a cooling conduit 234₁ having an inlet 238a₁ and an outlet 238b₁. An inlet tube 350₁ having a first end 352₁ and a second end 354₁ carries a cooling fluid into the cooling module 230₁. The first end 352₁ of the inlet tube 350₁ is coupled to a first quick connector 370a₁ and the second end 354₁ of the inlet tube 350₁ is coupled to the inlet 238a₁ of the cooling conduit 234₁. An outlet tube 360₁ having a first end 362₁ and a second end 364₁ carries the cooling fluid out of the cooling module 230₁. The first end 362₁ of the inlet tube 360₁ is coupled to the outlet 238b₁ of the cooling conduit 234₁ and the second end 364₁ is coupled to a second quick connector 370b₁. In some embodiments, the first quick connector 370a₁ and the second quick connector 370b₁ are plug-and-socket structures made from aluminum, stainless steel, copper, nickel, and the like. The arrows through the inlet tube 350₁, the cooling conduit 234₁, and the outlet tube 360₁ indicate direction of flow of the cooling fluid through the cooling module 230₁.

Similarly, the cooling module 230₂ is thermally coupled to a heat-generating component (not shown). As shown in FIG. 3A, the cooling module 230₂ includes a pump 236₂ fluidly connected to a cooling conduit 234₂ having an inlet 238a₂ and an outlet 238b_{2.} An inlet tube 350₂ having a first end 352₂ and a second end 354₂ carries a cooling fluid into the cooling module 230₂. The first end 352₂ of the inlet tube 350₂ is coupled to a first quick connector 370a₂ and the second end 354₂ of the inlet tube 350₂ is coupled to the inlet 238a₂ of the cooling conduit 234₂. An outlet tube 360₂ having a first end 362₂ and a second end 364₂ carries the cooling fluid out of the cooling module 230₂. The first end 362₂ of the inlet tube 360₂ is coupled to the outlet 238b₂ of the cooling conduit 234₂, and the second end 364₂ is coupled to a second quick connector 370b₂. In some embodiments, the first quick connector 370a₂ and the second quick connector 370b₂ are plug-and-socket structures made from aluminum, stainless steel, copper, nickel, and the like. The arrows through the inlet tube 350₂, the cooling conduit 234₂, and the outlet tube 360₂ indicate direction of flow of the cooling fluid through the cooling module 230₂.

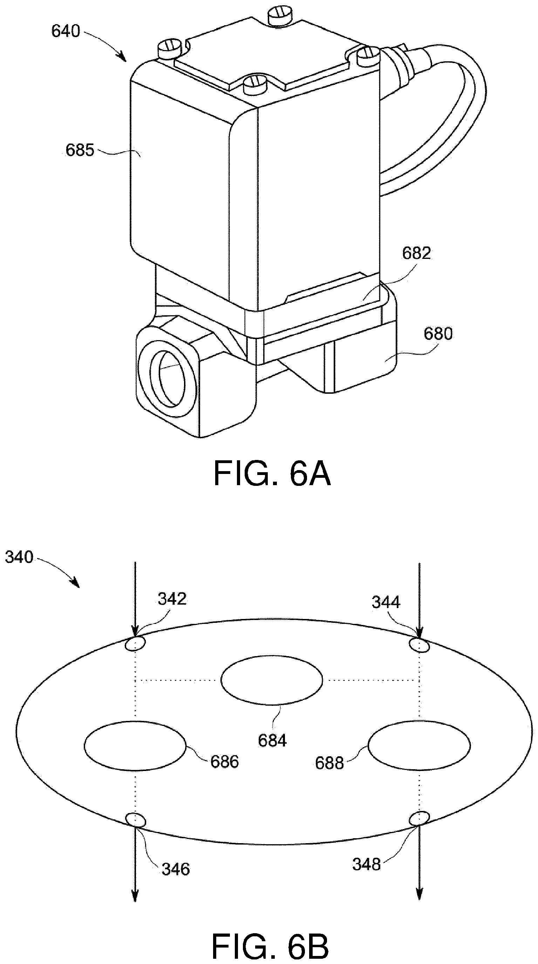

In the example arrangement of FIGS. 3A-3B, the cooling modules 230₁, 230₂ are interconnected by a single valve 340 having four ports 342, 344, 346, and 348. As shown and described below, the valve 340 is one of a four-pass actuated ball valve, a four-pass valve formed by three two-pass solenoid valves (see FIGS. 6A-6B), and the like. Two ports 342, 346 are fluidly coupled to the outlet tube 360₁ of the cooling module 230₁, and two ports 344, 348 are fluidly coupled to the inlet tube 350₂ of the cooling module 230₂. As shown in FIG. 3A, the valve 340 is initially turned off, and the cooling fluid flows independently through each of the cooling modules 230₁, 230₂. When the valve 340 is turned on, as shown in FIG. 3B triggered by an event (e.g., when one of the pumps 236₁ or 236₂ fails) as described below, the cooling fluid from the outlet tube 360₁ of the cooling module 230₁ is guided through the ports 342 and 344 of the valve 340 into the inlet tube 350₂ of the adjacent cooling module 230₂. This ensures that heat from the heat-generating components thermally coupled to the cooling modules 230₁, 230₂ can continue to be effectively removed.

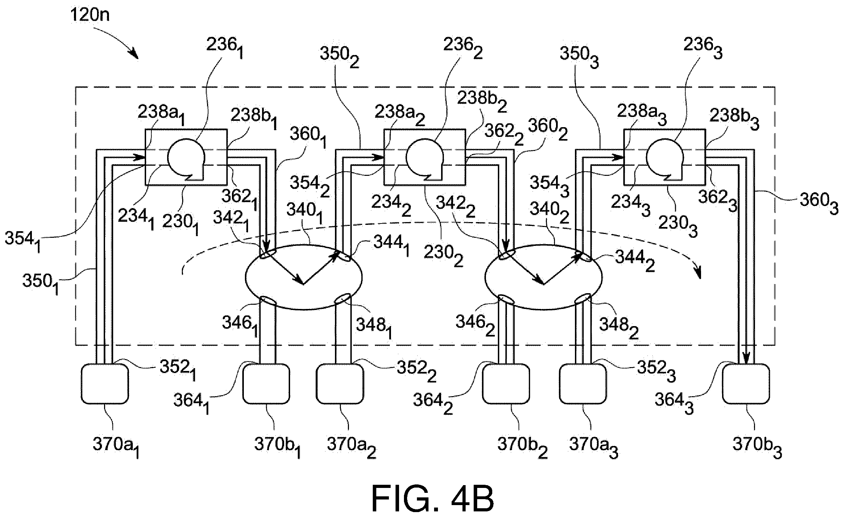

FIGS. 4A-4B show top views of a schematic depiction of another example arrangement of three adjacent cooling modules 230₁, 230₂, 230₃ arranged in parallel and interconnected by two valves 340₁, 340₂. The valves 340₁, 340₂ are initially turned off (FIG. 4A) and then both are turned on (though only one of the valves may be turned on as necessary) to allow cooling fluid to flow through the adjacent cooling modules 230₁, 230₂, 230₃ (FIG. 4B). The cooling modules 230₁, 230₂ are similar in structure and function, as described above with respect to FIGS. 3A-3B. The cooling module 230₃ is thermally coupled to a heat-generating component (not shown). As shown in FIG. 4A, the cooling module 230₃ includes a pump 230₃ fluidly connected to a cooling conduit 234₃ having an inlet 238a₃ and an outlet 238b₃. An inlet tube 350₃ having a first end 352₃ and a second end 354₃ carries a cooling fluid into the cooling module 230₃. The first end 352₃ of the inlet tube 350₃ is coupled to a first quick connector 370a₃, and the second end 354₃ of the inlet tube 350₃ is coupled to the inlet 238a₃ of the cooling conduit 234₃. An outlet tube 360₃ having a first end 362₃ and a second end 364₃ carries the cooling fluid out of the cooling module 230₃. The first end 362₃ of the inlet tube 360₃ is coupled to the outlet 238b₃ of the cooling conduit 234_{3,} and the second end 364₃ is coupled to a second quick connector 370b₃. In some embodiments, the first quick connector 370a₃ and the second quick connector 370b₃ are plug-and-socket structures made from aluminum, stainless steel, copper, nickel, and the like. The arrows through the inlet tube 350₃, the cooling conduit 234₃, and the outlet tube 360₃ indicate direction of flow of the cooling fluid through the cooling module 230₃.

In the example arrangement of FIGS. 4A-4B, the cooling modules 230₁, 230₂, 230₃ are interconnected by two valves 340₁, 340₂, similar to the valve 340. The valve 340₁ has four ports 342₁, 344₁, 346₁, and 348₁. Two ports 342₁, 346₁ are fluidly coupled to the outlet tube 360₁ of the cooling module 230₁, and two ports 344₁, 348₁ are fluidly coupled to the inlet tube 350₂ of the cooling module 230₂. Similarly, the valve 340₂ has four ports 342₂, 344₂, 346₂, and 348₂. Two ports 342₂, 346₂ are fluidly coupled to the outlet tube 360₂ of the cooling module 230₂, and two ports 344₂, 348₂ are fluidly coupled to the inlet tube 350₃ of the cooling module 230₃.

As shown in FIG. 4A, the valves 340₁, 340₂ are initially turned off, and the cooling fluid flows independently through each of the cooling modules 230₁, 230₂, 230₃. When the valves 340₁, 340₂ are turned on, as shown in FIG. 4B triggered by an event (e.g., when one of the pumps 236₁, 236₂, or 236₃ fails) as described below, the cooling fluid from the outlet tube 360₁ of the cooling module 230₁ is guided through the ports 342₁ and 344₁ of the valve 340₁ into the inlet tube 350₂ of the cooling module 230₂. Similarly, the cooling fluid from the outlet tube 360₂ of the cooling module 230₂ is guided through the ports 342₂ and 344₂ of the valve 340₂ into the inlet tube 350₃ of the cooling module 230₃. This ensures that heat from the heat-generating components thermally coupled to the cooling modules 230₁, 230₂, 230₃ can continue to be effectively removed. As illustrated through FIGS. 3A-3B and FIGS. 4A-4B, a plurality of cooling modules 230 can be interconnected through one or more valves 340 to achieve pump redundancy in the cooling circuit 120n, thereby ensure continuity and effectiveness of cooling of each of the servers 105n.

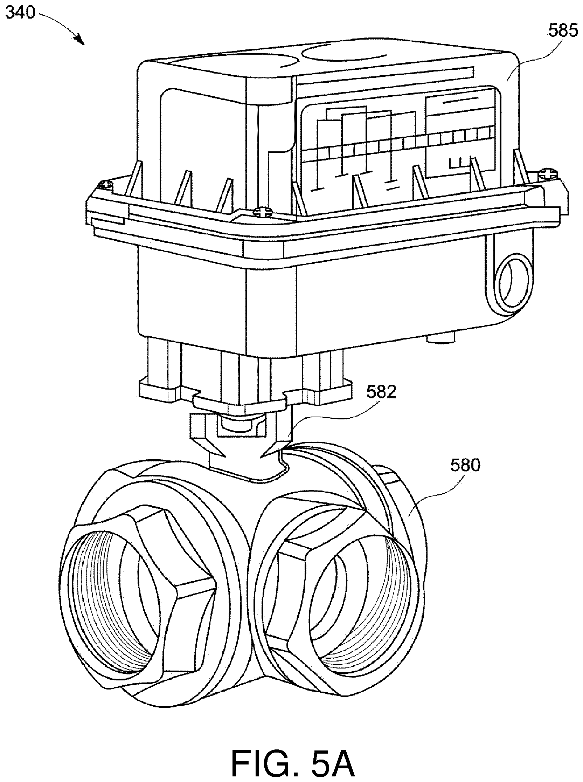

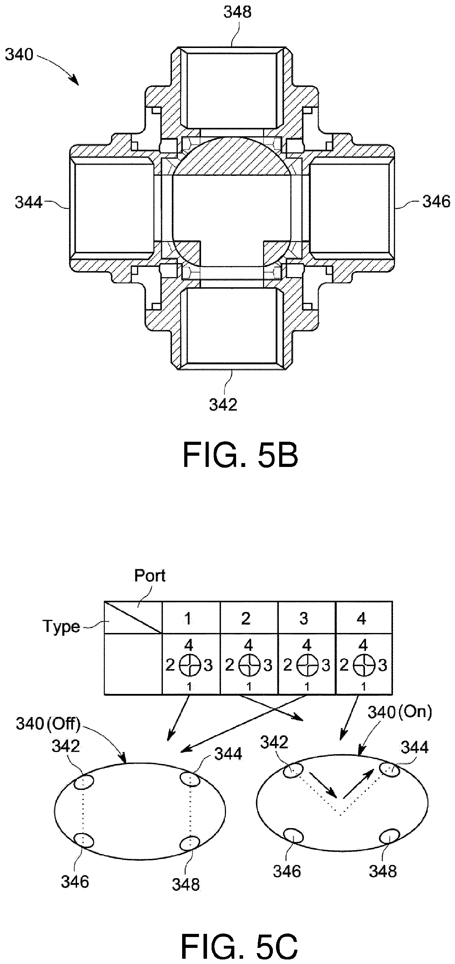

FIGS. 5A-5B show a perspective view and a top view respectively, of a first embodiment of the valve 340 used for interconnecting the adjacent cooling circuits. As shown in FIG. 5A, the valve 340 is a four-pass actuated ball valve. The valve 340 has a four-channeled structure 580 and a controlling unit 585 coupled to the four-channeled structure 580 through a connector 582. The four-channeled structure 580 has four ports 342, 344, 346, and 348, as shown in FIG. 5B (see also, FIGS. 3A-3B). In some embodiments, the four-channeled structure 580 is made from stainless steel.

In some embodiments, the controlling unit 585 is made from a polycarbonate material. The controlling unit 585 is configured to receive an input signal from a controller (e.g., the controller 106n of each server 105n) to adjust the position of the ports 342, 344, 346, and 348 in order to change direction of a fluid flowing through the valve 340 (e.g. the cooling fluid in the cooling circuit 120n of each server 105n). As an example, the valve 340 is thus configured to guide the cooling fluid from the cooling module 230₁ to the cooling module 230₂ in FIG. 3B.

FIG. 5C shows a schematic configuration of "on" and "off' states of the valve 340 of FIGS. 5A-5B. A ball (not shown) in the center of the four-channeled structure 580 (FIG. 5A) may be rotated by the controlling unit 585 to adjust the position of the ports 342, 344, 346, and 348, represented as "1", "2", "3", and "4" respectively in the chart of FIG. 5C. Accordingly, as shown in FIG. 5C, configurations of the ports 1, 2, 3, 4 in the first and the third columns represent an "off' state of the valve 340, and configurations of the ports 1, 2, 3, 4 in the second and fourth columns represents an "on" state of the valve 340.

FIGS. 6A-6B shows a perspective view and a schematic representation respectively, of a second embodiment of the valve 640 used for interconnecting the adjacent cooling circuits. As shown in FIG. 6A, the valve 640 is a two-pass solenoid valve having a two-channeled structure 680 and a controlling unit 685 coupled to the two-channeled structure 680 through a connector 682. As shown in FIG. 6B, three two-pass solenoid valves 684, 686, 688 form the four-pass valve 340 (see also, FIGS. 3A-3B) through connectors such that the four-pass valve 340 has the four ports 342, 344, 346, and 348. The valve 340 is off when the two-pass solenoid valve 684 is closed and the two-pass solenoid valves 686, 688 are open, such that the port 342 connects with the port 346 and the port 344 connects with the port 348. The valve 340 is on when the solenoid valve 684 is open and the solenoid valves 686, 688 are closed, such that the port 342 connects to the port 344.

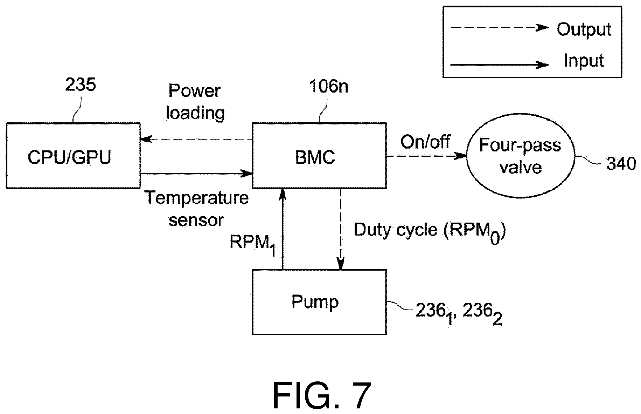

FIG. 7 shows a schematic representation of the operation of the controller 106n in each server 105n of the rack 100 (FIG. 1). The controller 106n is a baseboard management controller (BMC) that is a specialized microcontroller embedded in the motherboard of each server 105n. The controller 106n has its own firmware and random access memory (RAM). The controller 106n manages the interface between the system-management software and platform hardware of the server 105n and performs a number of functions in the server 105n, as shown in FIG. 7. The controller 106n receives data from sensors (e.g., temperature sensor, cooling fan speed sensor, cooling pump speed sensor, etc.) and determines whether the corresponding system parameters (e.g., temperature, cooling fan speed, cooling pump speed) are operating within predetermined ranges. When the controller 106n determines that a system parameter is outside the predetermined range, it undertakes a remedial action. The remedial action may include notifying an operator, who can then remote communicate with the controller 106n to take corrective action.

As an example, when the controller 106n determines from the received information that the revolutions per minute (RPM) of the one or more pumps 236₁, 236₂ (e.g., pumps 236₁, 236₂ in the cooling modules 230₁, 230₂ respectively in FIGS. 3A-3B) is outside a predetermined range of values, it determines that the corresponding one of the pumps 236₁, 236₂ has failed. Consequently, in response to detecting that any one of the pumps 236₁, 236₂ has failed, the controller 106n turns on the valve 340 connecting the cooling conduit (e.g., the cooling conduit 234₁ of the cooling module 230₁ in FIGS. 3A-3B) having the failed pump with the cooling conduit of an adjacent cooling module (e.g., the cooling conduit 234₂ of the cooling module 230₂ in FIGS. 3A-3B). In some embodiments, the controller 106n is also configured to send an alarm or an alert to an operator, in response to detecting at least that all but one of the pumps 236 in the plurality of cooling modules 230 has failed.

As another example, the controller 106n may receive temperature information of the heat-generating component 235 (FIGS. 2A-2B) thermally connected with the cold plate 232 (FIGS. 2A-2B) from the temperature sensors 108n (FIG. 1) in the corresponding server 105n. In response to detecting that the temperature of the heat-generating component 235 is above a predetermined range or that one of the pumps 236₁, 236₂ has failed, the controller 106n may adjust an electrical power load on the heat-generating component 235.

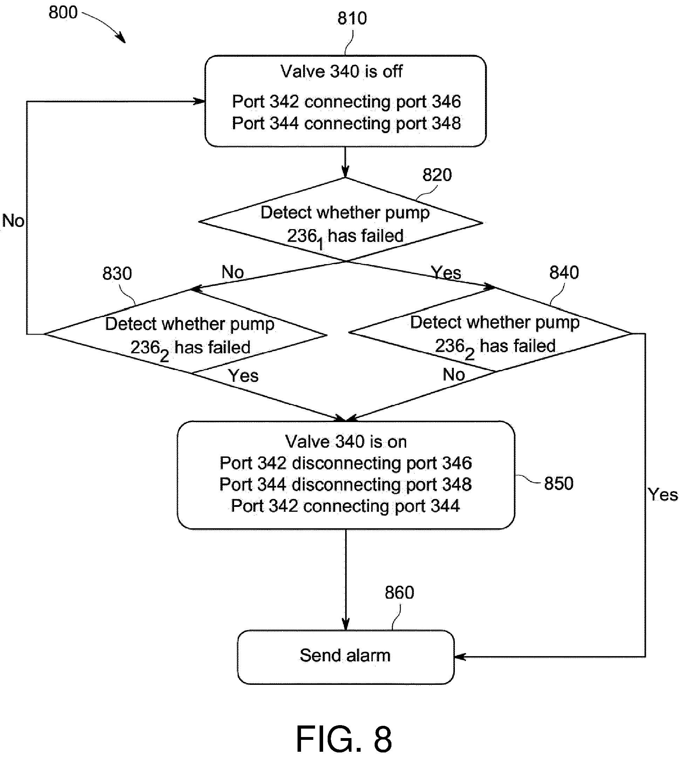

FIG. 8 shows a flow diagram of a flow control method 800 executed by the controller 106n in the server 105n (FIG. 1). The flow control method 800 starts in step 810, where the valve 340 is turned off such that port 342 is connected to port 346 (shown in FIG. 3A) and port 344 is connected to port 348 (shown in FIG. 3A). The flow control method 800 moves to decision point 820 to detect whether pump 236₁ (shown in FIG. 3B) has failed. If the pump 236₁ is not determined to have failed at decision point 820, the flow control method 800 moves to decision point 830 to detect whether pump 236₂ has failed. If the pump 236₂ is not determined to have failed at decision point 830, the flow control method 800 returns to step 810 to keep the valve 340 turned off. If the pump 236₂ is determined to have failed at decision point 830, the flow control method 800 moves to step 850 to turn the valve 340 on such that port 342 disconnects from the port 346, the port 344 disconnects from the port 348, and the port 342 connects with the port 344.

If the pump 236₁ is determined to have failed at decision point 820, the flow control method 800 moves to decision point 840 to detect whether pump 236₂ has failed. If the pump 236₂ is not determined to have failed at decision point 840, the flow control method 800 moves to step 850 to turn the valve 340 on such that port 342 disconnects from the port 346, the port 344 disconnects from the port 348, and the port 342 connects with the port 344. If the pump 236₂ is determined to have failed at decision point 840, the flow control method 800 moves to step 860 to send an alarm to an operator to take remedial action. In some embodiments, the alarm may also be sent from step 850 after turning the valve 340 on to notify the operator that one of the pumps 236₁, 236₂ has failed.

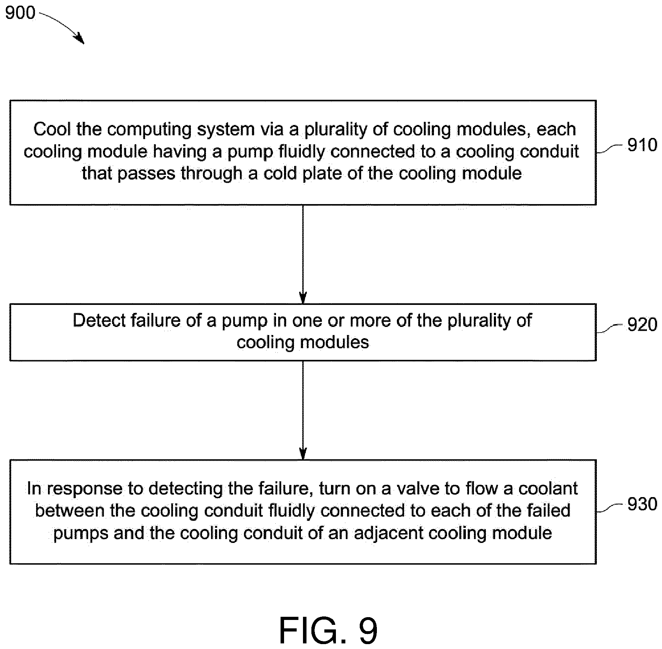

FIG. 9 shows a block diagram 900 of a flow control method for the cooling circuits (e.g., cooling circuits 120a, 120b, ..., 120n of the respective servers 105a, 105b, ..., 105n in FIG. 1). In block 910, the method cools the computing system via a plurality of cooling modules, where each cooling module has a pump fluidly connected to a cooling conduit that passes through a cold plate of the cooling module.

In block 920, the method detects failure of a pump in one or more of the plurality of cooling modules. In some implementations, detecting the failure may be based on receiving information on revolutions per minute (RPM) of the one or more pumps and determining whether the RPM of any of the one or more pumps is outside a predetermined range of values.

In block 930, in response to detecting the failure, a valve is turned on to flow a coolant between the cooling conduit fluidly connected to each of the failed pumps and the cooling conduit of an adjacent cooling module. In some implementations, the electrical power load on a heat-generating component thermally coupled to the cooling circuit is adjusted, in response to detection of the failure. In some implementations, an alarm may be sent to an operator, in response to detecting at least that all but one of the pumps in the plurality of cooling modules have failed.

Advantageously, the cooling mechanism described herein provides pump redundancy during operation such that heat from the heat-generating components in all parts of the computing devices can continue to be effectively removed, without unnecessary heating of the cooling fluid. The flow of the cooling fluid is automatically adjusted by opening a valve interconnecting adjacent cooling modules, upon detecting failure of one or more pumps configured to drive the cooling fluid in the cooling modules. An alarm is also sent to the operator in the event of critical pump failures that may affect the ability of the cooling modules to continuously remove heat from the heat-generating components.

Although the disclosed embodiments have been illustrated and described with respect to one or more implementations, equivalent alterations and modifications will occur or be known to others skilled in the art upon the reading and understanding of this specification and the annexed drawings within the limits of the appended claims. In addition, while a particular feature of the invention may have been disclosed with respect to only one of several implementations, such feature may be combined with one or more other features of the other implementations as may be desired and advantageous for any given or particular application within the limits of the appended claims.

While various embodiments of the present disclosure have been described above, it should be understood that they have been presented by way of example only, and not limitation. Numerous changes to the disclosed embodiments can be made in accordance with the disclosure herein within the limits of the appended claims. Thus, the breadth and scope of the present disclosure should not be limited by any of the above described embodiments. Rather, the scope of the disclosure should be defined within the limits of the appended claims.

## Claims

1. A cooling system for a rack (100) of servers (105a, 105b, ···, 105n), comprising:
a plurality of cooling circuits (120a, 120b, ···, 120n), each cooling circuit (120a, 120b,···, 120n) coupled to a server (105a, 105b, ···, 105n) of the rack (100) and comprising:
a plurality of cooling modules (230, 2301, 2302, 2303) arranged in parallel, each cooling module (230, 2301, 2302, 2303) including a cold plate (232) having a cooling conduit (234, 2341, 2342, 2343) passing therethrough, and a pump (236, 2361, 2362, 2363) fluidly coupled to the cooling conduit (234, 2341, 2342, 2343);
a first cooling distribution manifold (122) fluidly connected to the cooling circuit (120a, 120b, ···, 120n) of each of the plurality of servers (105a, 105b, ···, 105n) through an inlet pipe (124a, 124b, ···, 124n); and
a second cooling distribution manifold (126) fluidly connected to the cooling circuit (120a, 120b, ···, 120n) of each of the plurality of servers (105a, 105b, ···, 105n) through an outlet pipe (128a, 128b, ···, 128n);
wherein the cooling system is **characterized in that** any two adjacent cooling modules (230₁, 230₂,230₃) are interconnected by a valve (340, 340₁, 340₂) having four ports (342, 344, 346, 348, 342₁, 344₁, 346₁, 348₁, 342₂, 344₂, 346₂, 348₂), the valve (340, 340₁, 340₂) is one of a four-pass actuated ball valve and a four-pass valve formed by three two-pass solenoid valves, two of the ports (342, 344, 346, 348, 342₁, 344₁, 346₁, 348₁, 342₂, 344₂, 346₂, 348₂) are fluidly coupled to an outlet tube (360₁, 360₂, 360₃) of each cooling module (230₁, 230₂, 230₃), and another two of the ports (342, 344, 346, 348, 342₁, 344₁, 346₁, 348₁, 342₂, 344₂, 346₂, 348₂) are fluidly coupled to an inlet tube (350₁, 350₂, 350₃) of each cooling module (230₁, 230₂, 230₃).

2. The cooling system of claim 1, wherein the inlet tube (350₁, 350₂, 350₃) has a first end (352₁, 352₂, 352₃) coupled to a first quick connector (370a1, 370a2, 370a3) and a second end (354₁, 354₂, 354₃) coupled to an inlet (238a, 238a1, 238a2, 238a3) of the cooling conduit (234, 234₁, 234₂, 234₃), wherein the outlet tube (360₁, 360₂, 360₃) has a first end (362₁, 362₂, 362₃) coupled to an outlet (238b, 238b1, 238b2, 238b3) of the cooling conduit (234, 234₁, 2342, 234₃) and a second end (364₁, 364₂, 364₃) coupled to a second quick connector (370b1, 370b2, 370b3).

3. The cooling system of claim 1, further comprising:
a cooling distribution unit (190) disposed on the rack (100) of servers (105a, 105b, ···, 105n) for distributing a cooling fluid to the first cooling distribution manifold (122) and receiving the cooling fluid from the second cooling distribution manifold (126).

4. The cooling system of claim 3, wherein the cooling distribution unit (190) further comprises:
one or more sensors (198) configured to detect one or more flow parameters of the cooling fluid;
a cooling distribution pump (196) configured to controllably distribute the cooling fluid; and
a programmable logic controller (195) configured to control the flow rate of the cooling fluid from the cooling distribution pump (196) based on data received on the one or more flow parameters of the cooling fluid.

5. The cooling system of claim 1, wherein each cooling circuit (120a, 120b, ···, 120n) is communicatively coupled to a controller (106a, 106b, ···, 106n) in the corresponding server (105a, 105b, ···, 105n), the controller (106a, 106b, ···, 106n) configured to:
detect whether one or more of the pumps (236, 236₁, 236₂, 236₃) in the plurality of cooling modules (230, 230₁, 230₂, 230₃) has failed; and
turn on the one or more valves (340, 340₁, 340₂, 640) fluidly connecting the cooling conduit (23₄, 234₁, 234₂, 234₃) of the cooling module (230, 230₁, 230₂, 230₃) having each of the one or more failed pumps (236, 236₁, 236₂, 236₃) with the cooling conduit (234, 234₁, 234₂, 234₃) of an adjacent cooling module (230, 230₁, 230₂, 230₃), in response to such detection.

6. The cooling system of claim 5, wherein the controller (106a, 106b, ···, 106n) is further configured to:
receive temperature information of a heat-generating component (235) thermally connected with the cold plate (232) from a temperature sensor (108a, 108b, ···, 108n) in the corresponding server (105a, 105b, ···, 105n); and
adjust an electrical power load on the heat-generating component (235), in response to detecting that the one or more of the pumps (236, 236₁, 236₂, 236₃) in the plurality of cooling modules (230, 230₁, 230₂, 230₃) has failed.

7. The cooling system of claim 5, wherein the controller (106a, 106b, ···, 106n) is further configured to detect whether the one or more pumps (236, 236₁, 236₂, 236₃) has failed by:
receiving information on revolutions per minute (RPM) of the one or more pumps (236, 236₁, 236₂, 236₃); and
determining whether the RPM of any of the one or more pumps (236, 236₁, 236₂, 236₃) is outside a predetermined range of values.

8. A flow control method for a cooling circuit (120a, 120b, ···, 120n) of a computing system, **characterized in that** the method comprises:
cooling the computing system via a plurality of cooling modules (230, 230₁, 230₂, 230₃),each cooling module (230, 230₁, 230₂, 230₃) having a pump (236, 236₁, 236₂, 236₃) fluidly connected to a cooling conduit (234, 234₁, 234₂, 234₃) that passes through a cold plate (232) of the cooling module (230, 230₁, 230₂, 230₃);
detecting failure of a pump (236, 236₁, 236₂, 236₃) in one or more of the plurality of cooling modules (230, 230₁, 230₂, 230₃); and
in response to detecting the failure, turning on a valve (340, 340₁, 340₂, 640) having four ports (342, 344, 346, 348, 342₁, 344₁, 346₁, 348₁, 342₂, 344₂, 346₂, 348₂) to flow a coolant between the cooling conduit (234, 234₁, 234₂, 234₃) fluidly connected to each of the failed pumps (236, 236₁, 236₂, 236₃) and the cooling conduit (234, 234₁, 234₂, 234₃) of an adjacent cooling module (230, 230₁, 230₂, 230₃), wherein any two adjacent cooling modules (230₁, 230₂, 230₃) are interconnected by the valve (340, 340₁, 340₂), the valve (340, 340₁, 340₂) is one of a four-pass actuated ball valve and a four-pass valve formed by three two-pass solenoid valves, two of the ports (342, 344, 346, 348, 342₁, 344₁, 346₁, 348₁, 342₂, 344₂, 346₂, 348₂) are fluidly coupled to an outlet tube (360₁, 360₂, 360₃) of each cooling module (230₁, 230₂, 230₃), and another two of the ports (342, 344, 346, 348, 342₁, 344₁, 346₁, 348₁, 342₂, 344₂, 346₂, 348₂) are fluidly coupled to an inlet tube (350₁, 350₂, 350₃) of each cooling module (230₁, 230₂, 230₃).

9. The method of claim 8, further comprising adjusting electrical power load on a heat generating component (235) thermally coupled to the cooling circuit (120a, 120b, ···, 120n), in response to detecting the failure.

10. The method of claim 8, further comprising sending an alarm to an operator, in response to detecting at least that all but one of the pumps (236, 236₁, 236₂, 236₃) in the plurality of cooling modules (230, 230₁, 230₂, 230₃) have failed.

11. The method of claim 8, wherein detecting the failure of a pump (236, 236₁, 236₂, 236₃) in one or more of the plurality of cooling modules (230, 230₁, 230₂, 230₃) comprises:
receiving information on revolutions per minute (RPM) of the pump (236, 236₁, 236₂, 236₃); and :
determining whether the RPM of the pump (236, 236₁, 236₂, 236₃) is outside a predetermined range of values.

## Patentansprüche

1. Kühlsystem für ein Rack (100) mit Servern (105a, 105b, ..., 105n), umfassend:
eine Vielzahl von Kühlkreisläufen (120a, 120b, ..., 120n), wobei jeder Kühlkreislauf (120a, 120b, ..., 120n) an einen Server (105a, 105b, ..., 105n) des Racks (100) gekoppelt ist, und umfassend:
eine Vielzahl von Kühlmodulen (230, 2301, 2302, 2303), die parallel zueinander geschaltet sind, wobei jedes Kühlmodul (230, 2301, 2302, 2303) eine Kälteplatte (232) umfasst, die eine Kühlleitung (234, 2341, 2342, 2343) aufweist, die durch dieselbe verläuft, und eine Pumpe (236, 2361, 2362, 2363), die in Fluidkopplung zu der Kühlleitung (234, 2341, 2342, 2343) steht;
einen ersten Kühlverteiler (122), der über ein Einlassrohr (124a, 124b, ..., 124n) in Fluidverbindung mit dem Kühlkreislauf (120a, 120b,..., 120n) jedes der Vielzahl von Servern (105a, 105b, ..., 105n) steht; und
einen zweiten Kühlverteiler (126), der über ein Auslassrohr (128a, 128b, ..., 128n) in Fluidverbindung mit dem Kühlkreislauf (120a, 120b,..., 120n) jedes der Vielzahl von Servern (105a, 105b, ..., 105n) steht;
wobei das Kühlsystem **dadurch gekennzeichnet ist, dass** zwei beliebige benachbarte Kühlmodule (230₁, 230₂, 230₃) durch ein Ventil (340, 340₁, 340₂) mit vier Anschlüssen (342, 344, 346, 348, 342₁, 344₁, 346₁, 348₁, 342₂, 344₂, 346₂, 348₂) miteinander verbunden sind, das Ventil (340, 340₁, 340₂) entweder ein Vierwege-Schaltkugelventil oder ein Vierwegeventil, das durch drei Zweiwege-Magnetventile gebildet wird, ist, zwei der Anschlüsse (342, 344, 346, 348, 342₁, 344₁, 346₁, 348₁, 342₂, 344₂, 346₂, 348₂) in Fluidkopplung zu einem Auslassrohr (360₁, 360₂, 360₃) jedes Kühlmoduls (230₁, 230₂, 230₃) stehen und zwei andere der Anschlüsse (342, 344, 346, 348, 342₁, 344₁, 346₁, 348₁, 342₂, 344₂, 346₂, 348₂) in Fluidkopplung zu einem Einlassrohr (350₁, 350₂, 350₃) jedes Kühlmoduls (230₁, 230₂, 230₃) stehen.

2. Kühlsystem gemäß Anspruch 1, wobei das Einlassrohr (350₁, 350₂, 350₃) ein erstes Ende (352₁, 352₂, 352₃), das an einen ersten Schnellanschluss (370a1, 370a2, 370a3) gekoppelt ist, und ein zweites Ende (354₁, 354₂, 354₃), das an einen Einlass (238a, 238a1, 238a2, 238a3) der Kühlleitung (234, 234₁, 234₂, 234₃) gekoppelt ist, aufweist, wobei das Auslassrohr (360₁, 360₂, 360₃) ein erstes Ende (362₁, 362₂, 362₃), das an einen Auslass (238b, 238b1, 238b2, 238b3) der Kühlleitung (234, 234₁, 2342, 234₃) gekoppelt ist, und ein zweites Ende (364₁, 364₂, 364₃), das an einen zweiten Schnellanschluss (370b1, 370b2, 370b3) gekoppelt ist, aufweist.

3. Kühlsystem gemäß Anspruch 1, weiterhin umfassend:
eine Kühlverteilungseinheit (190), die sich auf dem Rack (100) mit Servern (105a, 105b, ..., 105n) befindet, zum Verteilen eines Kühlfluids auf den ersten Kühlverteiler (122) und Aufnehmen des Kühlfluids aus dem zweiten Kühlverteiler (126).

4. Kühlsystem gemäß Anspruch 3, wobei die Kühlverteilungseinheit (190) weiterhin umfasst:
einen oder mehrere Sensoren (198), die so konfiguriert sind, dass sie einen oder mehrere Strömungsparameter des Kühlfluids erfassen, können;
eine Kühlverteilungspumpe (196), die so konfiguriert ist, dass sie das Kühlfluid steuerbar verteilen kann; und
eine speicherprogrammierbare Steuerung (195), die so konfiguriert ist, dass sie die Strömungsgeschwindigkeit des Kühlfluids aus der Kühlverteilungspumpe (196) auf der Basis von Daten, die sie über den einen oder die mehreren Strömungsparameter des Kühlfluids empfängt, steuern kann.

5. Kühlsystem gemäß Anspruch 1, wobei jeder Kühlkreislauf (120a, 120b, ..., 120n) mit einem Steuerungsgerät (106a, 106b, ..., 106n) in dem entsprechenden Server (105a, 105b, ..., 105n) kommunikativ gekoppelt ist, wobei das Steuerungsgerät (106a, 106b, ..., 106n) so konfiguriert ist, dass es
erfassen kann, ob eine oder mehrere der Pumpen (236, 236₁, 236₂, 236₃) in der Vielzahl von Kühlmodulen (230, 230₁, 230₂, 230₃) ausgefallen sind; und
als Reaktion auf eine solche Erfassung ein oder mehrere Ventile (340, 340₁, 340₂, 640), die eine Fluidverbindung zwischen der Kühlleitung (23₄, 234₁, 234₂, 234₃) des Kühlmoduls (230, 230₁, 230₂, 230₃), das jede der einen oder mehreren ausgefallenen Pumpen (236, 236₁, 236₂, 236₃) aufweist, und der Kühlleitung (234, 234₁, 234₂, 234₃) eines benachbarten Kühlmoduls (230, 230₁, 230₂, 230₃) herstellen, einschalten kann.

6. Kühlsystem gemäß Anspruch 5, wobei das Steuerungsgerät (106a, 106b, ..., 106n) weiterhin so konfiguriert ist, dass es:
Temperaturdaten einer wärmeerzeugenden Komponente (235), die thermisch mit der Kälteplatte (232) verbunden ist, von einem Temperatursensor (108a, 108b, ..., 108n) in dem entsprechenden Server (105a, 105b, ..., 105n) empfangen kann; und
als Reaktion auf das Erfassen, das die eine oder die mehreren der Pumpen (236, 236₁, 236₂, 236₃) in der Vielzahl von Kühlmodulen (230, 230₁, 230₂, 230₃) ausgefallen sind, eine Stromlast an der wärmeerzeugenden Komponente (235) einstellen kann.

7. Kühlsystem gemäß Anspruch 5, wobei das Steuerungsgerät (106a, 106b,
..., 106n) weiterhin so konfiguriert ist,
dass es erfassen kann, ob die eine oder die mehreren Pumpen (236, 236₁, 236₂, 236₃) ausgefallen sind, und zwar durch:
Empfangen von Daten zur Drehzahl (U/min) der einen oder der mehreren Pumpen (236, 236₁, 236₂, 236₃); und
Bestimmen, ob die Drehzahl einer der einen oder der mehreren Pumpen (236, 236₁, 236₂, 236₃) außerhalb eines vorbestimmten Wertebereichs liegt.

8. Strömungskontrollverfahren für einen Kühlkreislauf (120a, 120b, ..., 120n) eines Rechnersystems, **dadurch gekennzeichnet, dass** das Verfahren Folgendes umfasst:
Kühlen des Rechnersystems über eine Vielzahl von Kühlmodulen (230, 230₁, 230₂, 230₃), wobei jedes Kühlmodul (230, 230₁, 230₂, 230₃) eine Pumpe (236, 236₁, 236₂, 236₃) aufweist, die in Fluidverbindung mit einer Kühlleitung (234, 234₁, 234₂, 234₃) steht, welche durch eine Kälteplatte (232) des Kühlmoduls (230, 230₁, 230₂, 230₃) verläuft;
Erfassen, ob eine Pumpe (236, 236₁, 236₂, 236₃) in einem oder mehreren der Vielzahl von Kühlmodulen (230, 230₁, 230₂, 230₃) ausgefallen ist; und
als Reaktion auf das Erfassen des Ausfalls, Einschalten eines Ventils (340, 340₁, 340₂, 640) mit vier Anschlüssen (342, 344, 346, 348, 342₁, 344₁, 346₁, 348₁, 342₂, 344₂, 346₂, 348₂), so dass ein Kühlmittel zwischen der Kühlleitung (234, 234₁, 234₂, 234₃), die in Fluidverbindung mit jeder der ausgefallenen Pumpen (236, 236₁, 236₂, 236₃) steht, und der Kühlleitung (234, 234₁, 234₂, 234₃) eines benachbarten Kühlmoduls (230, 230₁, 230₂, 230₃) strömt, wobei zwei beliebige benachbarte Kühlmodule (230₁, 230₂, 230₃) durch das Ventil (340, 340₁, 340₂) miteinander verbunden sind, das Ventil (340, 340₁, 340₂) entweder ein Vierwege-Schaltkugelventil oder ein Vierwegeventil, das durch drei Zweiwege-Magnetventile gebildet wird, ist, zwei der Anschlüsse (342, 344, 346, 348, 342₁, 344₁, 346₁, 348₁, 342₂, 344₂, 346₂, 348₂) in Fluidkopplung zu einem Auslassrohr (360₁, 360₂, 360₃) jedes Kühlmoduls (230₁, 230₂, 230₃) stehen und zwei andere der Anschlüsse (342, 344, 346, 348, 342₁, 344₁, 346₁, 348₁, 342₂, 344₂, 346₂, 348₂) in Fluidkopplung zu einem Einlassrohr (350₁, 350₂, 350₃) jedes Kühlmoduls (230₁, 230₂, 230₃) stehen.

9. Verfahren gemäß Anspruch 8, weiterhin umfassend das Einstellen einer Stromlast an einer wärmeerzeugenden Komponente (235), die mit dem Kühlkreislauf (120a, 120b, ..., 120n) thermisch gekoppelt ist, als Reaktion auf die Erfassung des Ausfalls.

10. Verfahren gemäß Anspruch 8, weiterhin umfassend das Senden eines Alarms an eine Bedienperson als Reaktion auf das Erfassen, dass wenigstens alle außer einer der Pumpen (236, 236₁, 236₂, 236₃) in der Vielzahl von Kühlmodulen (230, 230₁, 230₂, 230₃) ausgefallen sind.

11. Verfahren gemäß Anspruch 8, wobei das Erfassen des Ausfalls einer Pumpe (236, 236₁, 236₂, 236₃) in einem oder mehreren der Vielzahl von Kühlmodulen (230, 230₁, 230₂, 230₃) Folgendes umfasst:
Empfangen von Daten zur Drehzahl (U/min) der Pumpe (236, 236₁, 236₂, 236₃); und
Bestimmen, ob die Drehzahl der Pumpe (236, 236₁, 236₂, 236₃) außerhalb eines vorbestimmten Wertebereichs liegt.

## Revendications

1. Système de refroidissement pour une baie (100) de serveurs (105a, 105b, ..., 105n), comprenant :
une pluralité de circuits de refroidissement (120a, 120b, ..., 120n), chaque circuit de refroidissement (120a, 120b, ..., 120n) étant couplé à un serveur (105a, 105b, ..., 105n) de ladite baie (100), et comprenant :
une pluralité de modules de refroidissement (230, 2301, 2302, 2303) arrangés en parallèle, chaque module de refroidissement (230, 2301, 2302, 2303) incluant une plaque froide (232) ayant une conduite de refroidissement (234, 2341, 2342, 2343) passant à travers, et une pompe (236, 2361, 2362, 2363) en couplage de fluide avec ladite conduite de refroidissement (234, 2341, 2342, 2343),
une première tubulure de distribution de refroidissement (122) raccordée fluidiquement avec le circuit de refroidissement (120a, 120b, ..., 120n) de chacun de la pluralité de serveurs (105a, 105b, ..., 105n) à travers un tuyau d'admission (124a, 124b, ..., 124n), et
une deuxième tubulure de distribution de refroidissement (126) raccordée fluidiquement avec le circuit de refroidissement (120a, 120b, ..., 120n) de chacun de la pluralité de serveurs (105a, 105b, ..., 105n) à travers un tuyau de sortie (128a, 128b, ..., 128n),
dans lequel ledit système de refroidissement est **caractérisé en ce que** deux modules de refroidissement (230₁, 230₂, 230₃) adjacents quelconques sont reliés l'un à l'autre au moyen d'une vanne (340, 340₁, 340₂) ayant quatre raccords (342, 344, 346, 348, 342₁, 344₁, 346₁, 348₁, 342₂, 344₂, 346₂, 348₂), ladite vanne (340, 340₁, 340₂) est soit une vanne sphérique actionnée quatre voies soit une vanne quatre voies formée par trois électrovannes deux voies, deux des raccords (342, 344, 346, 348, 342₁, 344₁, 346₁, 348₁, 342₂, 344₂, 346₂, 348₂) sont couplés fluidiquement avec un tube de sortie (360₁, 360₂, 360₃) de chaque module de refroidissement (230₁, 230₂, 230₃), et deux autres des raccords (342, 344, 346, 348, 342₁, 344₁, 346₁, 348₁, 342₂, 344₂, 346₂, 348₂) sont couplés fluidiquement avec un tube d'admission (350₁, 350₂, 350₃) de chaque module de refroidissement (230₁, 230₂, 230₃).

2. Système de refroidissement selon la revendication 1, dans lequel ledit tube d'admission (350₁, 350₂, 350₃) possède une première extrémité (352₁, 352₂, 352₃) couplée à un premier raccord rapide (370a1, 370a2, 370a3) et une deuxième extrémité (354₁, 354₂, 354₃) couplée à une entrée (238a, 238a1, 238a2, 238a3) de ladite conduite de refroidissement (234, 234₁, 234₂, 234₃), dans lequel ledit tube de sortie (360₁, 360₂, 360₃) présente une première extrémité (362₁, 362₂, 362₃) couplée à une sortie (238b, 238b1, 238b2, 238b3) de ladite conduite de refroidissement (234, 234₁, 234₂, 234₃), et une deuxième extrémité (364₁, 364₂, 364₃) couplée à un deuxième raccord rapide (370b1, 370b2, 370b3).

3. Système de refroidissement selon la revendication 1, comprenant en outre :
une unité de distribution de refroidissement (190) située sur baie (100) de serveurs (105a, 105b, ..., 105n) pour distribuer un fluide de refroidissement à la première tubulure de distribution de refroidissement (122), et pour recevoir ledit fluide de refroidissement provenant de la deuxième tubulure de distribution de refroidissement (126).

4. Système de refroidissement selon la revendication 3, dans lequel ladite unité de distribution de refroidissement (190) comprend en outre :
un ou plusieurs capteurs (198) configurés pour détecter un ou plusieurs paramètres d'écoulement du fluide de refroidissement,
une pompe de distribution de refroidissement (196) configurée pour distribuer le fluide de refroidissement d'une manière commandable, et
un automate programmable industriel (195) configuré pour commander le débit du fluide de refroidissement à partir de la pompe de distribution de refroidissement (196) sur la base de données reçues sur l'un ou plusieurs paramètres d'écoulement du fluide de refroidissement.

5. Système de refroidissement selon la revendication 1, dans lequel chaque circuit de refroidissement (120a, 120b, ..., 120n) est couplé de manière communicative à un contrôleur (106a, 106b, ..., 106n) dans le serveur correspondant (105a, 105b, ..., 105n), ledit contrôleur (106a, 106b, ..., 106n) étant configuré pour
détecter si une ou plusieurs des pompes (236, 236₁, 236₂, 236₃) dans la pluralité de modules de refroidissement (230, 230₁, 230₂, 230₃) ont défailli, et
allumer lesdites une ou plusieurs vannes (340, 340₁, 340₂, 640) qui raccordent fluidiquement ladite conduite de refroidissement (234, 234₁, 234₂, 234₃) dudit module de refroidissement (230, 230₁, 230₂, 230₃) ayant chacune desdites pompes défaillies (236, 236₁, 236₂, 236₃) à ladite conduite de refroidissement (234, 234₁, 234₂, 234₃) d'un module de refroidissement adjacent (230, 230₁, 230₂, 230₃), en réponse à une telle détection.

6. Système de refroidissement selon la revendication 5, dans lequel ledit contrôleur (106a, 106b, ..., 106n) est configuré en outre pour
recevoir des données de température d'un composant générateur de chaleur (235) raccordé thermiquement à ladite plaque froide (232) provenant d'un capteur de température (108a, 108b, ..., 108n) dans le serveur correspondant (105a, 105b, ..., 105n), et
ajuster une charge de courant au composant générateur de chaleur (235) en réponse à la détection que l'une ou plusieurs des pompes (236, 236₁, 236₂, 236₃) dans la pluralité de modules de refroidissement (230, 230₁, 230₂, 230₃) ont défailli.

7. Système de refroidissement selon la revendication 5, dans lequel ledit contrôleur (106a, 106b, ..., 106n) est configuré en outre pour
détecter si l'une ou plusieurs des pompes (236, 236₁, 236₂, 236₃) ont défailli en :
recevant des données sur les vitesses de rotation (tr/min) desdites une ou plusieurs de pompes (236, 236₁, 236₂, 236₃), et
déterminant si la vitesse de rotation de l'une quelconque desdites une ou plusieurs pompes (236, 236₁, 236₂, 236₃) est en dehors d'une rangée de valeurs prédéterminée.

8. Procédé de commande d'écoulement pour un circuit de refroidissement (120a, 120b, ..., 120n) d'un système informatique, **caractérisé en ce que** ledit procédé comprend les étapes consistant à :
refroidir ledit système informatique via une pluralité de modules de refroidissement (230, 230₁, 230₂, 230₃),chaque module de refroidissement (230, 230₁, 230₂, 230₃) présentant une pompe (236, 236₁, 236₂, 236₃) raccordée fluidiquement avec une conduite de refroidissement (234, 234₁, 234₂, 234₃) qui passe à travers une plaque froide (232) dudit module de refroidissement (230, 230₁, 230₂, 230₃),
détecter la défaillance d'une pompe (236, 236₁, 236₂, 236₃) dans un ou plusieurs de ladite pluralité de modules de refroidissement (230, 230₁, 230₂, 230₃), et
en réponse à la détection de la défaillance, allumer une vanne (340, 340₁, 340₂, 640) ayant quatre raccords (342, 344, 346, 348, 342₁, 344₁, 346₁, 348₁, 342₂, 344₂, 346₂, 348₂) pour faire s'écouler un refroidisseur entre la conduite de refroidissement (234, 234₁, 234₂, 234₃) raccordée fluidiquement avec chacune des pompes défaillies (236, 236₁, 236₂, 236₃) et la conduite de refroidissement (234, 234₁, 234₂, 234₃) d'un module de refroidissement adjacent (230, 230₁, 230₂, 230₃), dans lequel deux modules de refroidissement (230₁, 230₂, 230₃) adjacents quelconques sont raccordés l'un à l'autre par la vanne (340, 340₁, 340₂), ladite vanne (340, 340₁, 340₂) est soit une vanne sphérique actionnée quatre voies soit une vanne quatre voies formée par trois électrovannes deux voies, deux des raccords (342, 344, 346, 348, 342₁, 344₁, 346₁, 348₁, 342₂, 344₂, 346₂, 348₂) sont couplés fluidiquement avec un tube de sortie (360₁, 360₂, 360₃) de chaque module de refroidissement (230₁, 230₂, 230₃), et deux autres des raccords (342, 344, 346, 348, 342₁, 344₁, 346₁, 348₁, 342₂, 344₂, 346₂, 348₂) sont couplés fluidiquement avec un tube d'admission (350₁, 350₂, 350₃) de chaque module de refroidissement (230₁, 230₂, 230₃).

9. Procédé selon la revendication 8, comprenant en outre l'étape consistant à : ajuster la charge de courant sur un composant générateur de chaleur (235) couplé thermiquement audit circuit de refroidissement (120a, 120b, ..., 120n) en réponse à la détection de la défaillance.

10. Procédé selon la revendication 8, comprenant en outre l'étape consistant à : envoyer une alerte à un opérateur en réponse à la détection au moins que toutes les pompes (236, 236₁, 236₂, 236₃) à l'exception d'une seule dans la pluralité de modules de refroidissement (230, 230₁, 230₂, 230₃) ont défailli.

11. Procédé selon la revendication 8, dans lequel la détection de la défaillance d'une pompe (236, 236₁, 236₂, 236₃) dans un ou plusieurs de ladite pluralité de modules de refroidissement (230, 230₁, 230₂, 230₃) comprend les étapes consistant à :
recevoir des données sur les vitesses de rotation (tr/min) de la pompe (236, 236₁, 236₂, 236₃), et
déterminer si la vitesse de rotation de la pompe (236, 236₁, 236₂, 236₃) est en dehors d'une rangée de valeurs prédéterminée.
